# EUROPEAN PATENT APPLICATION

(11) **EP 1 500 981 A1**
(43) Date of publication of application: **26.01.2005**
(21) Application number: 03254630.1
(22) Date of filing: 23.07.2003
(51) Int. Cl.: G03F 7/20

(54) **Lithographic apparatus and device manufacturing method**

(71) Applicant: ASML Netherlands B.V., 5504 DR Veldhoven (NL)
(72) Inventor: The designation of the inventor has not yet been filed
(74) Representative: Leeming, John Gerard

(57) **Abstract**

The pulse-to-pulse dose reproducibility of a radiation system for use in maskless lithography is improved by providing a plurality of lasers and combing the radiation beams produced by each to form a single projection beam of radiation.

## Description

The present invention relates to a lithographic projection apparatus comprising:
- a radiation system for supplying a projection beam of radiation;
- programmable patterning means for patterning the projection beam according to a desired pattern;
- a substrate table for holding a substrate; and
- a projection system for projecting the patterned beam onto a target portion of the substrate.

Lithographic projection apparatus are used in the manufacture of integrated circuits (ICs), flat panel displays and other devices involving fine structures. The programmable patterning means generates a pattern corresponding to an individual layer of, for example, the IC, and this pattern is imaged onto a target portion (e.g. comprising part of, one or several dies) on a substrate (e.g. silicon wafer or glass plate) that has been coated with a layer of radiation-sensitive material (resist).

Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. These transfer procedures result in a patterned layer of resist on the substrate. One or more pattern steps, such as deposition, etching, ion-implantation (doping), metallization, oxidation, chemo-mechanical polishing, etc., follow, each of which is intended to finish, create or modify a layer of the device. If several layers are required, then the whole procedure, or a variant thereof, is repeated for each new layer. Eventually, an array of devices will be present on the substrate (wafer). These devices are then separated from one another by a technique such as dicing or sawing, whence the individual devices can be mounted on a carrier, connected to pins, etc.. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

When performing lithography using an apparatus with a programmable patterning means, so-called maskless lithography, it is important to ensure that the intensity of the radiation produced by the radiation system does not vary significantly over a sequence of exposures. For example, the pulse-to-pulse dose reproducibility required may be approximately 1%. However, lasers that are presently used for lithography do not achieve this level of pulse-to-pulse dose reproducibility. In particular, presently used excimer lasers have a pulse-to-pulse dose reproducibility of only about 10%.

It is an object of the present invention to provide a radiation source for maskless lithography with an improved pulse-to-pulse dose reproducibility.

This and other objects are achieved according to the invention in a lithographic apparatus as specified in the opening paragraph, characterized in that said radiation system comprises a plurality of radiation generating units, each producing a sub-projection beam of radiation; and a combining unit that combines each of the sub-projection beams to form said projection beam of radiation.

Consequently, even if the pulse-to-pulse dose reproducibility of each of the radiation generating units is not good enough for use in maskless lithography, the variations average out and the output of the complete radiation system is a projection beam of radiation with sufficient pulse-to-pulse dose reproducibility for use in maskless lithography.

Preferably, each of the radiation generating units produce radiation at substantially the same wavelength in order to produce a projection beam of radiation with a narrow spectrum.

A plurality of the radiation generating units may be lasers that are contained within a single housing and which share a common laser gas. Therefore, although each of these radiation generating units produces a laser pulse independently, the complexity of the radiation system as a whole is minimised.

The radiation generating units within such a housing may each comprise a pair of independent discharge electrodes. Alternatively, these radiation generating units may share one common discharge electrode and each also have an independent discharge electrode.

For convenience, the housing containing several radiation generating units may also contain a blower for mixing the laser gas within the housing and/or a temperature controller for regulating the temperature of the laser gas. By sharing such utilities, the complexity of the radiation system is further minimised.

The radiation system may contain a plurality of housings, each containing a plurality of the radiation generating units, sharing some or all utilities. This permits a large number of radiation generating units to be incorporating in the radiation system, without the complexity of each housing becoming too great.

Alternatively and/or additionally, the radiation system may comprise a plurality of radiation generating units that are independent lasers. Controlling the timing of the independent lasers is more complicated. However, because the lasers are entirely independent, the intensity radiation of each laser is also entirely independent and therefore the pulse-to-pulse dose reproducibility of the radiation system as a whole is improved.

In order to reduce the complexity of the radiation system, some or all of the radiation generating units may share a common control system.

The sub-projection beams produced by each of the radiation generating units may be combined to form the projection beam of radiation using a diffractive element or a micro lens array.

In general, the greater the number of radiation generating units used, the greater the improvement in the pulse-to-pulse dose reproducibility. Using conventional excimer lasers, preferably 100 or more radiation generating units are used.

According to a further aspect of the invention there is provided:
a device manufacturing method comprising the steps of:
   - providing a substrate;
   - providing a projection beam of radiation using a radiation system;
   - using programmable patterning means to pattern the projection beam; and
   - projecting the patterned beam of radiation onto a target portion of the substrate;
characterized by said radiation system comprising a plurality of radiation generating units and said method comprises using said radiation generating units to provide a plurality of sub-projection beams of radiation and combining them to provide said projection beam of radiation.

The term "programmable patterning means" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. An array of grating light valves (GLV) can also be used in a corresponding manner. Each GLV is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the programmable patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

It should be appreciated that where pre-biasing of features, optical proximity correction features, phase variation techniques and multiple exposure techniques are used, the pattern "displayed" on the programmable patterning means may differ substantially from the pattern eventually transferred to a layer of or on the substrate.

For the sake of simplicity, the projection system may be referred to as the "lens"; however, this term should be broadly interpreted as encompassing various types of projection system, including refractive optics, reflective optics, catadioptric systems and micro lens arrays, for example. It is to be understood that the term "projection system" as used in this application simply refers to any system for transferring the patterned beam from the programmable patterning means to the substrate. The radiation system may also include components operating according to any of these design types for directing, shaping or controlling the projection beam of radiation, and such components may also be referred to below, collectively or singularly, as a "lens". It has been proposed to fill a space between the final element of the projection system and the substrate with a liquid that has a refractive index of greater than one. This enables imaging of smaller features because the exposure radiation will have a shorter wavelength in liquid. The present invention may be used with apparatus of this type. Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, thin film transistor liquid crystal displays, printed circuit boards (PCBs), etc.

In the present document, the terms "radiation" and "beam" are used to encompass all types of electromagnetic radiation, including ultraviolet radiation (*e*.*g*. with a wavelength of 365, 248, 193, 157 or 126 nm) and EUV (extreme ultra-violet radiation, *e*.*g*. having a wavelength in the range 5-20 nm), as well as particle beams, such as ion beams or electron beams.

Exemplary embodiments of the invention will now be described, by way of example only, with reference to the accompanying schematic drawings, in which:
Figure 1 depicts a lithographic projection apparatus according to an embodiment of the invention;
Figure 2 depicts, in cross-section, a conventional excimer laser;
Figure 3 depicts a side view of a conventional excimer laser;
Figure 4 depicts, in cross-section, a multi-laser unit according to the present invention;
Figure 5 depicts, in cross-section, a variant of the multi-laser unit shown in figure 4; and
Figure 6 depicts a beam combining unit that could be used in the present invention.

In the Figures, corresponding reference symbols indicate corresponding parts.

### Embodiment 1

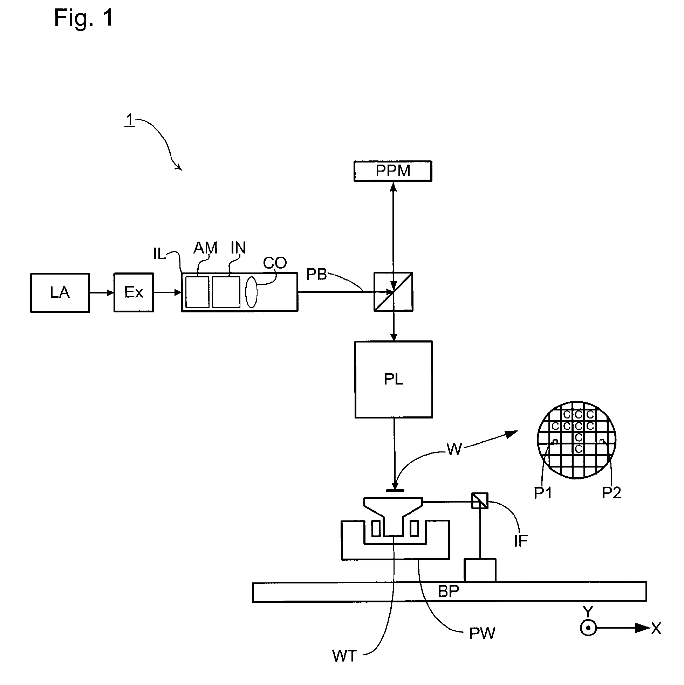

Figure 1 schematically depicts a lithographic projection apparatus according to a particular embodiment of the invention. The apparatus comprises:
- a radiation system Ex, IL, for supplying a projection beam PB of radiation (*e*.*g*. UV radiation), which in this particular case also comprises a radiation source LA;
- a programmable patterning means PPM (e.g. a programmable mirror array) for applying a pattern to the projection beam; in general the position of the programmable patterning means will be fixed relative to item PL; however it may instead be connected to a positioning means for accurately positioning it with respect to item PL;
- an object table (substrate table) WT provided with a substrate holder for holding a substrate W (*e.g.* a resist-coated silicon wafer), and connected to positioning means for accurately positioning the substrate with respect to item PL;
- a projection system ("lens") PL (*e*.*g*. a quartz and/or CaF₂ lens system or a catadioptric system comprising lens elements made from such materials, or a mirror system) for projecting the patterned beam onto a target portion C (*e.g.* comprising one or more dies) of the substrate W; the projection system may project an image of the programmable patterning means onto the substrate; alternatively, the projection system may project images of secondary sources for which the elements of the programmable patterning means act as shutters; the projection system may also comprise a micro lens array (known as an MLA), *e.g.* to form the secondary sources and to project microspots onto the substrate.

As here depicted, the apparatus is of a reflective type (*i.e.* has a reflective programmable patterning means). However, in general, it may also be of a transmissive type, for example (*i*.*e*. with a transmissive programmable patterning means).

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the programmable patterning means PPM has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the programmable patterning means PPM. Having been reflected by the programmable patterning means PPM, the beam PB passes through the projection system PL, which focuses the beam PB onto a target portion C of the substrate W. With the aid of the positioning means (and interferometric measuring means IF), the substrate table WT can be moved accurately, *e.g.* so as to position different target portions C in the path of the beam PB. Where used, the positioning means for the programmable patterning means can be used to accurately correct the position of the programmable patterning means PPM with respect to the path of the beam PB, *e.g.* during a scan. In general, movement of the object table WT is realized with the aid of a long-stroke module (course positioning) and a short-stroke module (fine positioning), which are not explicitly depicted in Figure 1. A similar system may also be used to position the programmable patterning means. It will be appreciated that the projection beam may alternatively/additionally be moveable while the object table and/or the programmable patterning means may have a fixed position to provide the required relative movement.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the entire pattern on the programmable patterning means is projected in one go (i.e. a single "flash") onto a target portion C. The substrate table WT is then moved in the x and/or y directions to a different position for a different target portion C to be irradiated by the beam PB.
2. Scan mode: essentially the same as step mode, except that a given target portion C is not exposed in a single "flash". Instead, the programmable patterning means is movable in a given direction (the so-called "scan direction", e.g. the y direction) with a speed v, so that the projection beam PB is caused to scan over the programmable patterning means; concurrently, the substrate table WT is simultaneously moved in the same or opposite direction at a speed V = Mv, in which M is the magnification of the lens PL. In this manner, a relatively large target portion C can be exposed, without having to compromise on resolution.
3. Pulse mode: the programmable patterning means is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the programmable patterning means is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the programmable patterning means is updated as the projection beam scans across the substrate and exposes it.

Combinations and/or variations on the above described modes of use or entirely different modes of use may also be employed.

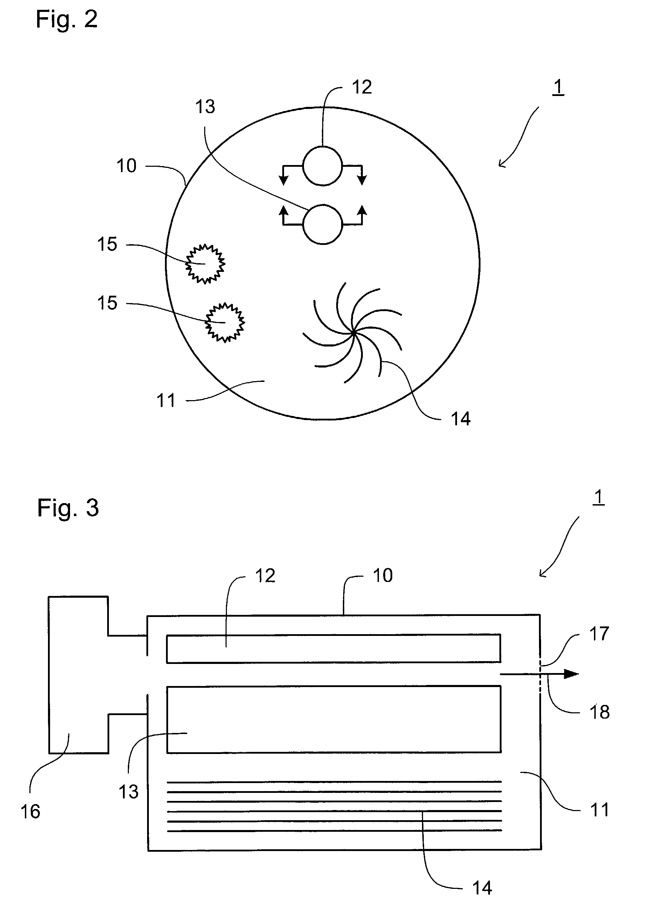

Figures 2 and 3 depict a conventional gas discharge laser 1, for example an excimer laser, in cross-section and side elevation, respectively. The gas laser 1 has a housing 10 in which is contained the laser gas 11 (which in the caser of an excimer laser may be for example XeF). Within the laser gas are a pair of discharge electrodes 12,13, a blower 14 for mixing the laser gas 11 in the housing 10 so that it is evenly distributed, and temperature controllers 15 to regulate the temperature of the laser gas. At one end of the laser 1 there is a mirror or line-width narrowing unit 16 and at the opposite end there is a semi-transparent mirror 17 from which the beam of laser radiation 18 is projected.

In the radiation system of the present invention, a plurality of radiation generating units are provided that each produce a sub-projection beam of radiation. Each of the sub-projection beams of radiation are then combined to form the projection beam of radiation which is used to expose the substrate.

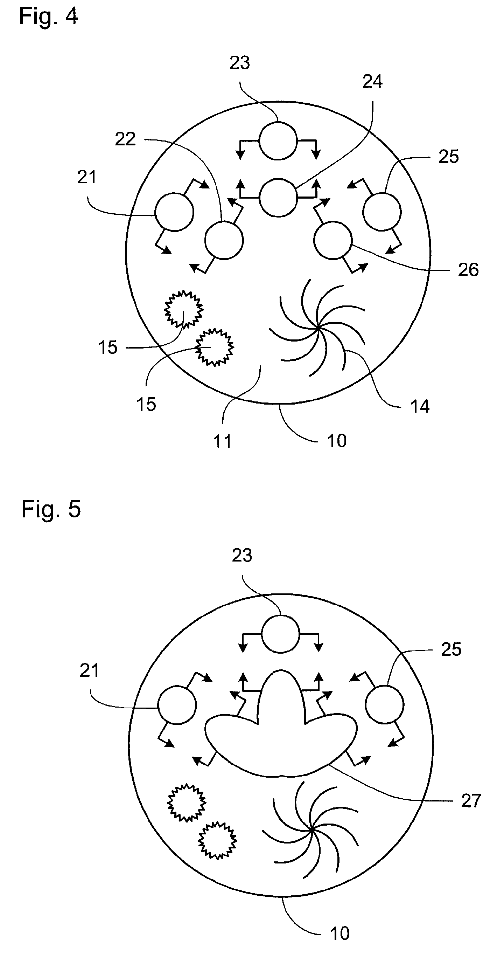

Each of the radiation generating units may be an independent, conventional, laser. Alternatively and/or additionally, some of the radiation generating units may share components. Figures 4 and 5 illustrate, in cross-section, such an arrangement.

In the arrangement shown in figure 4, three radiation generating units are enclosed within a single common housing 10 that contains a laser gas 11 that the radiation generating units share between them. The housing also contains a blower 14 and temperature control elements 15. Each radiation generating unit is comprised of a pair of discharge electrodes 21,22,23,24,25,26. Each pair of discharge electrodes generates a laser beam of radiation that is projected from a semi-transparent mirror at an end of the housing. It will be appreciated that there may be separate semi-transparent mirrors associated with each pair of discharge electrodes (and hence each sub-projection laser beam of radiation) or, alternatively, some or all of the pairs of discharge electrodes may project their associated laser beams of radiation through a common semi-transparent mirror.

The arrangement shown in figure 5 corresponds to that of figure 4, except that one of the discharge electrodes of each of the radiation generating units is replaced by a common discharge electrode 27. Consequently, each radiation generating unit is comprised of one independent discharge electrode 21,23,25 and a portion of the common discharge electrode 27.

Figures 4 and 5 both show arrangements in which three radiation generating units are contained in a single housing 10. It will be appreciated, however, that the housings may contain any practical number of radiation generating units. Furthermore, the complete radiation system of the present invention may be made up of any number of such housings. In general, the radiation system may be comprised of one or more such housings that each may contain one or more radiation generating units, such that the complete radiation system contains a plurality of radiation generating units. In addition, it is to be understood that it is not an essential feature of the invention for the radiation generating units within a single housing to have a common blower or common temperature control units.

In order to minimize the complexity of the radiation system, some or all of the radiation generating units may share common control electronics that are used to govern the timing of the pulses of radiation generated by the radiation generating units.

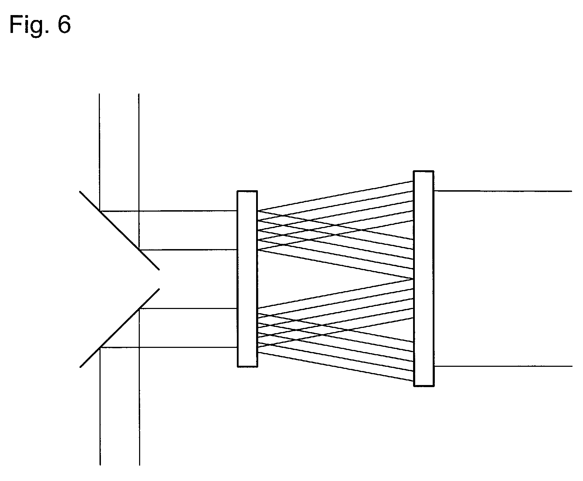

The sub-projection beams of radiation generated by each radiation generating unit are combined in a combining unit to form the projection beam of radiation. This may be effected by bringing the beams close together and then mixing them together using a diffractive element or a micro lens array (also known as a wedge array). An example of such an arrangement is shown in Figure 6.

When using a laser source of radiation in a lithographic projection apparatus, it is necessary to reduce the coherence of the laser beam because the field uniformity may otherwise be affected due to speckle. It is therefore conventional to project the laser beam of radiation through an integrator, as described above in relation to Figure 1. In the present invention, the combined projection beam of radiation may be projected through an integrator. Alternatively and/or additionally at least one of the sub-projection beams of radiation produced by the individual radiation generating units may be projected through an integrator prior to being combined into the projection beam of radiation in the combining unit. Alternatively, if the radiation system contains a sufficient number of radiation generating units, the coherence of the projection beam of radiation produced by combining the sub-projection beams from each of the radiation generating units may be inherently low enough that an integrator is not required.

Preferably at least 100 radiation generating units are used. With this number of radiation generating units, the coherence of the result in projection beam of radiation is sufficiently low that no integrator is required. Furthermore, the pulse-to-pulse dose reproducibility is improved by a factor of 10 in comparison to a single radiation generating unit of the type used. This would mean, for example, that the pulse-to-pulse dose reproducibility of a system using excimer lasers would be adequate for use in maskless lithography.

It is necessary to ensure that all of the radiation generating units produce pulses simultaneously in order to avoid pulse timing errors and to prevent the radiation pulse being spread over a longer time duration. In order to achieve this, it may be necessary for each of the radiation generating units, or at least each group of radiation generating units contained within a single housing, to be provided with its own timing circuitry to compensate for its specific timing characteristic. Such circuits will need to be calibrated and the calibration may need to be repeated periodically.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- programmable patterning means for patterning the projection beam according to a desired pattern;
- a substrate table for holding a substrate; and
- a projection system for projecting the patterned beam onto a target portion of the substrate;
**characterized in that** said radiation system comprises a plurality of radiation generating units, each producing a sub-projection beam of radiation; and a combining unit that combines each of the sub-projection beams to form said projection beam of radiation.

2. A lithographic projection apparatus according to claim 1, wherein said radiation generating units all generate radiation with substantially the same wavelength.

3. A lithographic projection apparatus according to claim 1 or 2, wherein a plurality of said radiation generating units are lasers contained in a single housing that share a common lasing medium.

4. A lithographic projection apparatus according to claim 3, wherein said radiation generating units contained in the single housing each comprise a pair of discharge electrodes independent from those of the other radiation generating units.

5. A lithographic projection apparatus according to claim 3, wherein said radiation generating units contained in said housing share a common discharge electrode and each also comprise a further discharge electrode independent from that of the other radiation generating units.

6. A lithographic projection apparatus according to any one of claims 3 to 5, wherein said housing further contains at least one of a blower for mixing the laser gas in the housing and a temperature controller for regulating the temperature of the laser gas in the housing.

7. A lithographic projection apparatus according to any one of claims 3 to 6, wherein said radiation system comprises a plurality of such housings, each containing a plurality of said radiation generating units sharing a common laser gas.

8. A lithographic projection apparatus according to any one of the preceding claims, wherein a plurality of said radiation generating units are independent lasers.

9. A lithographic projection apparatus according to any one of the preceding claims, wherein a plurality of said radiation generating units share a common control system.

10. A lithographic projection apparatus according to any one of the preceding claims, wherein said combining unit is a diffractive element or a micro lens array.

11. A lithographic projection apparatus according to any one of the preceding claims, wherein said radiation system comprises at least 100 radiation generating units.

12. A device manufacturing method comprising the steps of:
- providing a substrate;
- providing a projection beam of radiation using a radiation system;
- using programmable patterning means to pattern the projection beam; and
- projecting the patterned beam of radiation onto a target portion of the substrate;
**characterized by** said radiation system comprising a plurality of radiation generating units and said method comprises using said radiation generating units to provide a plurality of sub-projection beams of radiation and combining them to provide said projection beam of radiation.
